(19) Europäisches Patentamt / European Patent Office / Office européen des brevets

(11) **EP 4 272 007 B1**

(12) **EUROPÄISCHE PATENTSCHRIFT**

(45) Veröffentlichungstag und Bekanntmachung des Hinweises auf die Patenterteilung:
**11.02.2026 Patentblatt 2026/07**

(21) Anmeldenummer: **21839389.0**

(22) Anmeldetag: **13.12.2021**

(51) Internationale Patentklassifikation (IPC):
**G01R 31/26** (2020.01)

(52) Gemeinsame Patentklassifikation (CPC):
**G01R 31/2642;** G01R 31/2621; G01R 31/3277

(86) Internationale Anmeldenummer:
**PCT/EP2021/085451**

(87) Internationale Veröffentlichungsnummer:
**WO 2022/144166 (07.07.2022 Gazette 2022/27)**

(54) **VORRICHTUNG UND VERFAHREN ZUM ÜBERWACHEN EINES HALBLEITERBAUELEMENTS**

APPARATUS AND METHOD FOR MONITORING A SEMICONDUCTOR COMPONENT

APPAREIL ET PROCÉDÉ DE SURVEILLANCE D'UN COMPOSANT SEMI-CONDUCTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.01.2021 DE 102021200002**

(43) Veröffentlichungstag der Anmeldung:
**08.11.2023 Patentblatt 2023/45**

(73) Patentinhaber: **Robert Bosch GmbH**
**70442 Stuttgart (DE)**

(72) Erfinder:
• **SCHARY, Timo**
**72631 Aichtal-Neuenhaus (DE)**
• **MONTEIRO DINIZ REIS, Daniel**
**73734 Esslingen Am Neckar (DE)**
• **SCHATZ, Frank**
**70806 Kornwestheim (DE)**
• **MEWS, Mathias**
**72766 Reutlingen (DE)**

(56) Entgegenhaltungen:
WO-A1-2019/135247    DE-B3- 102016 109 137
US-A1- 2008 309 365    US-A1- 2019 369 157
US-B1- 6 348 806

• REIS DANIEL MONTEIRO DINIZ ET AL: "Leakage Current in Low-Temperature PVD PZT Films", 2019 IEEE INTERNATIONAL SYMPOSIUM ON APPLICATIONS OF FERROELECTRICS (ISAF), IEEE, 14 July 2019 (2019-07-14), pages 1 - 4, XP033740285, DOI: 10.1109/ ISAF43169.2019.9034930

**Beschreibung**

Stand der Technik

Die Erfindung geht aus von einer Vorrichtung und einem Verfahren zum Überwachen eines Halbleiterbauelements. Dielektrischer Durchbruch ist bei Halbleiterbauelementen bestehend aus mindestens zwei Elektroden und mindestens einer zwischenliegenden dielektrischen Schicht, die unter Anlegen einer elektrischen Spannung betrieben werden immer ein relevanter Faktor bezüglich deren Lebenszeit. Ein weiterer eine Lebenszeit des Halbleiterbauelements limitierender Faktor ist die Entwicklung hoher Leckströme oder der Abfall der Performance durch Zerstörung aktiver Fläche des Bauelements.

Aus den Dokumenten DE 10 2016 109137 B3, US 2019/369157 A1, US 6 348 806 B1 und der Veröffentlichung "Leakage Current in Low-Temperature PVD PZT Films" von Reis Daniel Monteiro Diniz et al. ist ein Verfahren zum Überwachen eines Halbleiterbauelements bekannt, welches zumindest teilweise Merkmale des Oberbegriffs des Verfahrens zum Überwachen eines Halbleiterbauelements gemäß Anspruch 1 umfasst.

Offenbarung der Erfindung

Durch die Vorrichtung und das Verfahren nach den unabhängigen Ansprüchen, können Halbleiterbauelemente mit dielektrischen Schichten im Betrieb überwacht und nicht nur deren Defekt festgestellt werden, sondern zudem eine Vorhersage der verbleibenden Lebenszeit "Remaining Useful Life" getroffen werden. Zusätzlich zu einer Kinetik bis zu einem dielektrischen Durchbruch werden dazu Rückschlüsse zu einem auf den dielektrischen Durchbruch nachfolgenden Degradationsablauf ermöglicht. Damit wird eine Lebenszeitüberwachung realisiert, die anhand eines Leckstromlevels und/oder eines ersten Durchbruchs "first peak" und/oder einer Performance des Halbeiterbauelements, hier einer Polarisation, eine Leckstromentwicklung sowie eine Entwicklung der Performance einschließt.

Das Verfahren zum Überwachen eines Halbleiterbauelements sieht vor, dass in einem Betrieb des Halbleiterbauelements ein Leckstrom erfasst wird, der durch eine erste Elektrode und eine zweite Elektrode des Halbleiterbauelements fliest, wobei der Leckstrom in einem Vergleich mit einem ersten Grenzwert für den Leckstrom verglichen wird und abhängig von einem Ergebnis des Vergleichs eine Ausgabe bestimmt wird und/oder wobei ein Zeitpunkt bestimmt wird, zu dem ein Extremalpunkt, insbesondere ein Maximum, des Leckstroms auftritt und abhängig vom Zeitpunkt eine Ausgabe bestimmt wird, wobei die Ausgabe einen Zustand des Halbleiterbauelements umfasst, und die Ausgabe ausgegeben wird. Dies ermöglicht es, einen inneren Zustand des Halbleiterbauelements für ein lifetime monitoring zugänglich zu machen.

Erfindungsgemäß ist vorgesehen, dass abhängig vom Zeitpunkt, zu dem der Extremalpunkt, insbesondere das Maximum, des Leckstroms auftritt, ein Restwert einer Lebensdauer des Halbleiterbauelements bestimmt wird, wobei die Ausgabe den Restwert umfasst.

Es kann vorgesehen sein, dass der Leckstrom in einem Betrieb des Halbleiterbauelements in einem ersten Betriebsmodus erfasst wird, wobei der Betrieb des Halbleiterbauelements im ersten Betriebsmodus fortgesetzt wird, wenn der Leckstrom den ersten Grenzwert überschreitet oder wenn der Restwert der Lebensdauer größer als ein erster Schwellwert ist.

Es kann vorgesehen sein, dass ein zweiter Grenzwert aus der Vielzahl der Grenzwerte bestimmt wird, wobei der Betrieb des Halbleiterbauelements in einem zweiten Betriebsmodus fortgesetzt wird oder der Betrieb beendet wird, wenn der Leckstrom den zweiten Grenzwert überschreitet oder dass der Betrieb des Halbleiterbauelements in einem zweiten Betriebsmodus fortgesetzt wird oder der Betrieb beendet wird, wenn der Restwert der Lebensdauer größer als ein zweiter Schwellwert ist.

Es kann vorgesehen sein, dass ein Referenzgrenzwert und eine Referenztemperatur vorgegeben werden, eine aktuelle Temperatur des Halbleiterbauelements oder einer Umgebung des Halbleiterbauelements bestimmt wird, ein Faktor abhängig von der aktuellen Temperatur und der Referenztemperatur bestimmt wird, der Referenzgrenzwert mit dem Faktor skaliert wird und der erste Grenzwert und/oder der zweite Grenzwert abhängig von dem mit dem Faktor skalierten Referenzgrenzwert bestimmt wird.

Es kann vorgesehen sein, dass ein Text bestimmt wird, der den Zustand des Halbleiterbauelements und eine Angabe über eine noch verbleibende Lebensdauer umfasst, wobei der Text in einer Nachricht versendet oder an einer Mensch-Maschine-Schnittstelle ausgegeben wird.

Es kann vorgesehen sein, dass ein Steuersignal bestimmt wird, das einen Betriebsmodus für das Halbleiterbauelement vorgibt, wobei das Steuersignal ausgegeben wird, um das Halbleiterbauelement oder ein Gerät, das das Halbleiterbauelement umfasst, zum Betrieb in dem Betriebsmodus ansteuert.

Die Vorrichtung zum Überwachen des Halbleiterbauelements gemäß der Erfindung wird in Anspruch 7 definiert.

Die Erfindung betrifft auch ein Micro-Electro-Mechanical System, MEMS, einen Speicher, einen Aktuator, einen Mikrospiegel, einen Druckkopf oder einen Lautsprecher der diese Vorrichtung zum Überwachen eines Halbleiterbauelements und das Halbleiterbauelement umfasst

Weitere vorteilhafte Ausführungsformen ergeben sich aus der folgenden Beschreibung und der Zeichnung. In der Zeichnung zeigt:

Fig. 1 eine schematische Darstellung eines Halbleiterbauelements,
Fig. 2 einen ersten Zustand für eine erste Verteilung von Defekten,
Fig. 3 einen zweiten Zustand für die erste Verteilung von Defekten,
Fig. 4 einen dritten Zustand für die erste Verteilung von Defekten,
Fig. 5 einen vierten Zustand für die erste Verteilung von Defekten,
Fig. 6 einen fünften Zustand für die erste Verteilung von Defekten,
Fig. 7 einen ersten Verlauf eines Leckstromlevels gemäß der ersten Verteilung,
Fig. 8 einen zweiten Verlauf eines Leckstromlevels gemäß der ersten Verteilung,
Fig. 9 einen ersten Zustand für eine zweite Verteilung von Defekten,
Fig. 10 einen zweiten Zustand für die zweite Verteilung von Defekten,
Fig. 11 einen dritten Zustand für die zweite Verteilung von Defekten,
Fig. 12 einen vierten Zustand für die zweite Verteilung von Defekten,
Fig. 13 einen fünften Zustand für die zweite Verteilung von Defekten,
Fig. 14 einen Verlauf eines Leckstromlevels gemäß der zweiten Verteilung,
Fig. 15 eine Vorrichtung zur Überwachung des Halbleiterbauelements,
Fig. 16 ein Verfahren zur Überwachung des Halbleiterbauelements.

Die folgende Beschreibung nutzt Kenntnisse eines Versagensmechanismus in dielektrischen Schichten aus, um im laufenden Betrieb eines Halbleiterbauelements, das eine dielektrische Schicht oder mehrere dielektrische Schichten umfasst, aus messbaren Veränderungen eine Vorhersage zu einer verbleibenden Lebensdauer abzuleiten. Diese kann in sicherheitsrelevanten Anwendungen dazu verwendet werden, individuelle, nutzungsspezifische Wartungsanweisungen oder Warnungen auszugeben.

Herkömmliche Lebenszeitangaben, Wartungsintervalle oder aktive Überwachungen von Bauteilen sind darauf ausgelegt kritische Fehler durch frühzeitigen Austausch zu verhindern oder einen Fehler anzuzeigen, wenn es bereits zu spät ist und ein Ausfall des Bauteils vorliegt. Die festgelegten Wartungs-/Tausch-Intervalle sind dabei statistisch ermittelt und spiegeln oftmals sehr konservative Grenzen für die Gesamtheit aller Teile unter einem angenommenen mittleren Belastungsprofil wieder. Belastungsprofile sind dabei entscheidend können jedoch nur geschätzt werden.

Demgegenüber wurde erfindungsgemäß festgestellt, dass in derartigen Halbleiterbauelementen ein deterministischer bzw. vorhersehbarer Degradationsverlauf vorliegt, bei dem ein kontinuierliches Versagen bzw. ein graduelles Verhalten beobachtet werden kann. Mittels dieser Kenntnis über das Verhalten kann das Bauteil spezifisch überwacht werden. Bei festgelegten Grenzwerten kann eine Warnung bzw. ein kontrollierter Tausch geplant werden. Wartung und Austausch können dadurch Bauteilspezifisch und abhängig von einem tatsächlichen Belastungsprofil ermittelt werden. Dies stellt einen Vorteil für einen Kunden dar, der ein Bauteil erst dann tauscht, wenn es tatsächlich notwendig ist.

Das graduelle Verhalten kann beispielsweise ein gradueller Leckstromanstieg oder gradueller Leistungs-/Performanceabfall sein.

In Halbleiterbauelementen mit einer dielektrischen Schicht, die zwischen zwei Elektroden angeordnet ist, kann ein Leckstrom auftreten. Ein Leckstromverlauf ändert sich z.B. durch Anlagerung von Defekten an einer Grenzschicht zwischen einem Dielektrikum der dielektrischen Schicht und einer der Elektroden. Defekte, die sich an der Grenzschicht anlagern haben einen Einfluss auf eine Barrierenhöhe. In Kenntnis einer initialen Barrierehöhen und der Parameter, die einen raumladungslimitierten Stromanteil, Space-Charge-Limited-Current, beschreiben, ist ein zeitlicher Verlauf des Leckstroms abbildbar. Es ist zudem möglich den Leckstromverlauf vor und nach einem ersten dielektrischen Durchbruch zu beschreiben. Aufgrund eines Zusammenhangs zwischen Leckstromdegradation und Performancedegradation ist es zudem möglich einen Performanceverlust zu beschreiben.

In einem Aspekt wird der Leckstrom überwacht. In einem Aspekt wird eine Performance des Halbleiterbauteils überwacht.

Es kann vorgesehen sein, in einer Überwachung ein Leckstromlevel zu bewerten und einen ersten Grenzwert zu definieren nach dem eine Warnung generiert wird und die Lebenszeit noch einen gewünschten Restwert besitzt.

Es kann vorgesehen sein, in der Überwachung einen Zeitpunkt zu bestimmen, zu dem ein erster Durchbruch, first peak, aufgetreten ist und eine Warnung inklusive Schätzung einer Restlebenszeit auszugeben, die sich aus der Entwicklung des Leckstromlevels oder des Performanceverlusts insbesondere abhängig von definierten produktspezifischen Grenzwerten ergibt.

Weil auch nach Erreichen des ersten Grenzwertes das Belastungsprofil eine hohe Rolle spielt, können mehrere Grenzwerte definiert werden und die aktive Überwachung fortgesetzt werden.

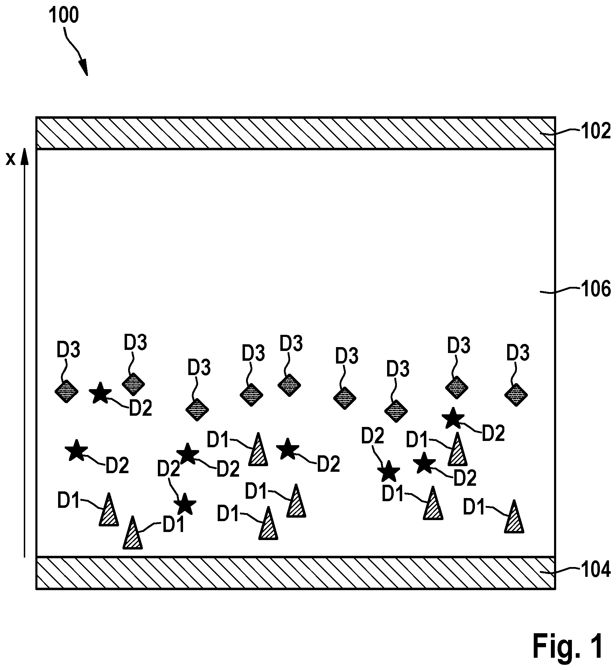

Figur 1 stellt eine schematische Darstellung eines Halbleiterbauelements 100 dar. Das Halbleiterbauelement 100 umfasst eine erste Elektrode 102, eine zweite Elektrode 104 und eine dielektrische Schicht 106.

Die dielektrische Schicht 106 ist zwischen der ersten Elektrode 102 und der zweiten Elektrode 104 angeordnet. Im Beispiel sind die erste Elektrode 102 und die zweite Elektrode 104 auf einander entgegengesetzten Seiten der dielektrischen Schicht 106 angeordnet.

In der dielektrischen Schicht 106 liegen im Beispiel Defekte D1 einer ersten Defektart, Defekte D2 einer zweiten Defektart und Defekte D3 einer dritten Defektart vor. Es können auch nur Defekte D1 der ersten Defektart oder nur Defekte zweier verschiedener Defektarten vorliegen. Es können auch Defekte von mehr als drei Defektarten vorliegen. Diese Defekte sind im Beispiel in einer Ausgangsposition angeordnet. Die Ausgangsposition ist im Beispiel durch einen Herstellungsprozess der dielektrischen Schicht definiert. Die Defekte sind im Beispiel in unterschiedlichen Abständen zur ersten Elektrode 102 bzw. zur zweiten Elektrode 104 angeordnet.

Bei den Defekten handelt es sich um geladene Defekte, die sich bei einem angelegten Potential zwischen der ersten Elektrode 102 und der zweiten Elektrode 104 entsprechend ihrer Ladung zu einer jeweiligen Grenzschicht zwischen dielektrischer Schicht 106 und entweder erster Elektrode 102 oder zweiter Elektrode 104 bewegen. Die Grenzschicht wird im Folgenden als "Interface" bezeichnet. Dieser Transport der geladenen Defekte wird dabei durch Defekteigenschaften und einem "Hopping Mechanismus" bestimmt.

Hopping-Mechanismus bedeutet in diesem Zusammenhang, dass eine Verlagerung, d.h. ein Hopping, der Defekte in einem durch die jeweilige angelegte Spannung U in der dielektrischen Schicht 106 der Dicke d wirkenden elektrischen Feld E stattfindet. Die Defekte einer Defektart i bewegen sich entlang lokalisierter Defektzustände mit einem mittleren effektiven Abstand $a_i$. Dies führt zu einer Geschwindigkeit $v_i$ der Bewegung der Defekte der Defektart i. Die Geschwindigkeit $v_i$ wird über den bekannten Ansatz von Variable Range Hopping beschrieben:

$$v_i = C_{0,i}(a_i)e^{-\frac{E_{A,0,i}}{k_B T}}sinh\left(\frac{N_{q,i}a_i E}{k_B T}\right) mit\ E = \frac{U}{d}$$

$$C_{0,i}(a_i) = v_0 a_i e^{-\frac{2a_i}{\alpha}}$$

Hierbei repräsentiert $C_{0,i}(a_i)$ eine Funktion, die einen Einfluss einer örtlichen Defektverteilung auf eine in der dielektrischen Schicht 106 charakteristische Geschwindigkeit $v_i$ der Defekte i darstellt. Diese Defektverteilung stellt eine Eigenschaft der dielektrischen Schicht 106 dar. Diese Eigenschaft bestimmt die Bewegung der Defekte der Defektart i in der dielektrischen Schicht 106 mit. Die Parameter Abklinglänge $\alpha$, mittlerer effektiver Abstand $a_i$, Aktivierungsenergie $E_{A,0,i}$, elektrische Ladung $N_{q,i}$ der Defekte der Defektart i sind physikalische Eigenschaften. Mit $k_B$ ist die Boltzmannkonstante bezeichnet. Mit T ist die Temperatur der Umgebung des betrachteten Defekts insbesondere die Temperatur in der dielektrischen Schicht 106 bezeichnet.

Bis zu einem dielektrischen Versagen kann ein zeitlicher Verlauf einer Leckstromdichte $J_{TED}$, über die Gleichung der Thermionic-Emission-Diffusion Theorie nach Crowell und Sze bestimmt werden:

$$J_{TED} = \frac{q N_C v_R}{1 + \frac{v_R}{v_D}} e^{\frac{-\Phi_B^{eff}}{k_B T}}\left[e^{\frac{qU}{k_B T}} - 1\right]$$

Hierbei repräsentiert q die Einheitsladung, $N_C$ die effektive Zustandsdichte im Leitungsband, $v_R$ die effektive Rekombinationsgeschwindigkeit, $v_D$ die effektive Diffusionsgeschwindigkeit, $\Phi_B^{eff}$ die effektive Schottky-Barriere, $k_B$ die Boltzmannkonstante, T die Temperatur der Umgebung und U Spannung über die dielektrische Schicht 106.

Defekte i mit positiver Ladung wandern zur Elektrode mit negativem Potential und lagern sich am Interface an. Defekte i mit negativer Ladung bewegen sich zur Elektrode mit positivem Potential, und lagern sich am Interface an. Dadurch ändert sich die effektive Schottky-Barriere $\Phi_B^{eff}$.

Eine Barrierenhöhenänderung $\Delta\Phi_i$, welche durch Defekte i erzeugt werden, ist gekennzeichnet durch ihre Maximalhöhe $\delta\Phi_i$ und eine charkteristische Zeitkonstante $\tau_i$. Die charkteristische Zeitkonstante $\tau_i$ definiert eine Zeitdauer, in der sich die Barrierenhöhenänderung $\Delta\Phi_i$ über der Zeit t am stärksten verändert:

$$\Delta\Phi_i(t) = \delta\Phi_i\left(1 - e^{\frac{t}{\tau_i}}\right)$$

Die Maximalhöhe $\delta\Phi_i$ ist eine Funktion einer Anzahl $Z_i$ von Defekten i und hängt von einer Art des Interface ab. Mit dem Term ( $1 - e^{\frac{t}{\tau_i}}$ ) wird die zeitabhängige Anlagerung einer statistische Verteilung der Defekte i im Material beschrieben insbesondere der Zeitpunkt der Anlagerung der jeweiligen Ausgangsposition. Die Ausgangsposition stellt im Beispiel einen Schwerpunkt der Verteilung dar. Sofern es mehrere Häufungen für die Defekte der Defektart i gibt, kann eine der Häufungen ausgewählt werden, die statt des Schwerpunkts die Ausgangsposition definiert. Vorzugsweise wird die Häufung ausgewählt, die den größten Einfluss auf die Erhöhung der Lebenszeit aufweist.

In der dielektrischen Schicht 106 können Defekte verschiedener Defektarten vorliegen. Es können Defekte existieren, die aufgrund ihrer Ladung eine die effektive Schottky-Barriere $\Phi_B^{eff}$ erhöhende Barrierenhöhenänderung $\Delta\Phi_i$ verursachen. Dadurch sinkt das Leckstromlevel ab. In diesem Kontext werden diese beispielhaft als "restaurierende" Defekte bezeichnet. Es können Defekte existieren, die aufgrund ihrer Ladung eine die effektive Schottky-Barriere $\Phi_B^{eff}$ verringernde Barrierenhöhenänderung $\Delta\Phi_i$ verursachen. Dadurch steigt das Leckstromlevel an. In diesem Kontext werden diese beispielhaft als "degradierende" Defekte bezeichnet.

Bei Anlegen einer Spannung werden die Defekte bewegt. Die Aktivierungsenergie und Ladung können dazu führen, dass bestimmte Defekte sehr viel schneller sind.

Eine Anfangsposition von Defekten i ist im Beispiel durch einen Abstand $d_i$ des Schwerpunktes ihrer Verteilung zum Interface definiert, dem die Defekte i im bestimmungsgemäßen Betrieb des Halbleiterbauteils 100 zustreben.

Die Zeitkonstante $\tau_i$ kann für die Bewegung unter dem Einfluss einer ersten Spannung U1 anders sein, als für die Bewegung unter dem Einfluss einer zweiten Spannung U2. Die Zeitkonstante $\tau_i$ kann durch eine Beweglichkeit der Defekte i unter einem Einfluss des elektrischen Feldes E in der dielektrischen Schicht 106 und durch den bis zum Erreichen des jeweiligen Interface zurückzulegenden Weg in der dielektrischen Schicht 106 definiert werden. Bei der Verlagerung im Inneren der dielektrischen Schicht 106 muss Defektart i den Abstand $d_i$ des Schwerpunktes seiner Verteilung zum Interface zurücklegen. Zusammen mit der Geschwindigkeit $v_i$ resultiert die charakteristische Zeitkonstante $\tau_i$ für den Anlagerungsprozess der Defekte i in

$$\tau_i = \frac{d_i}{v_i}$$

Aus einer Messung des Leckstroms über Zeit und Auswertung des zeitabhängigen Verlaufs mittels der Gleichungen der Thermionic-Emission-Diffusion Theorie nach Crowell und Sze und dem zeitabhängigen Verhalten der Barrierenhöhenänderung ist die Zeitkonstante $\tau_i$ bestimmbar. Mittels mehrerer Messungen von $\tau_i$ unter verschiedenen Temperaturen T und Spannungen U, kann die Aktivierungsenergie $E_{A,0,i}$ und die elektrische Ladung $N_{q,i}$ der Defekte der Defektart i bestimmt werden.

Unter Anlegen der ersten elektrischen Spannung U1 mit einer ersten Polarität bewegen sich die geladene Defekte in einer ersten Richtung zur ersten Elektrode 102. Unter Anlegen der zweiten elektrischen Spannung U2 mit einer der ersten elektrischen Spannung U1 entgegengesetzten Polarität, bewegen sich diese geladenen Defekte in einer zweiten Richtung hin zur zweiten Elektrode 102.

Geladene Defekte, die das Interface an der ersten Elektrode 102 oder der zweiten Elektrode 104 erreichen, lagern sich am Interface an.

Das Halbleiterbauelement 100 kann mehr als zwei Elektroden aufweisen. Das Halbleiterbauelement 100 kann mehr als eine zwischen jeweils zwei Elektroden liegende dielektrische Schicht aufweisen.

Bei derartigen Halbleiterbauelementen ist ein dielektrischer Durchbruch möglich, wenn diese unter Anlegen einer elektrischen Spannung betrieben werden. Wenn ein dielektrischer Durchbruch auftritt, wird das Interface teilweise oder vollständig zerstört. Wenn ein dielektrischer Durchbruch auftritt, wird eine Lebensdauer des Halbleiterbauelements 100 verkürzt. Der dielektrische Durchbruch tritt beispielsweise auf, wenn eine Anzahl von geladenen Defekten, die sich am Interface anlagern, den spannungsabhängigen Schwellwert überschreitet.

Durch eine Optimierung von Prozessbedingungen und/oder einer Prozessführung bei einer Herstellung der dielektrischen Schicht 106 können physikalische Eigenschaften und herstellungsspezifische Einflüsse auf diese physikalischen Eigenschaften beeinflusst werden. Dadurch kann die Lebensdauer verlängert werden.

Durch die Prozessbedingungen und/oder die Prozessführung wird beispielsweise ein Wachstum, Wachstumsbedingungen, eine Materialkomposition beeinflusst. Durch die Prozessbedingungen und/oder die Prozessführung entsteht beispielsweise eine gewollte oder ungewollte Dotierung und/oder Verunreinigung während des Wachstumsprozesses oder in Folgeprozessen.

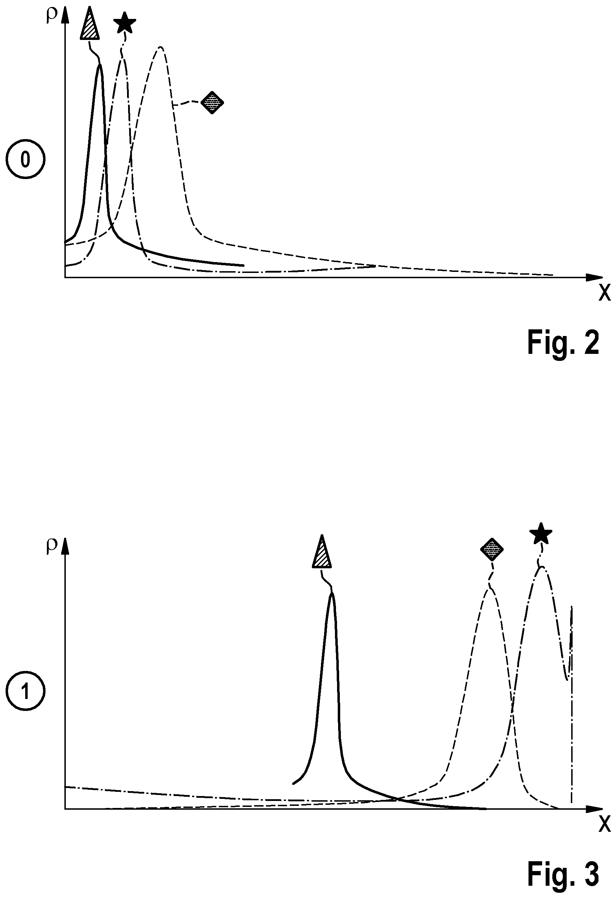

In Figur 2 ist ein erster Zustand für eine erste Verteilung p der Defekte über einen Abstand x von der zweiten Elektrode 104 dargestellt. Im Beispiel ist der erste Zustand ein Anfangszustand. Eine Verteilung der Defekte D1 der ersten Defektart ist in Figur 2 und den folgenden Figuren mit einem Dreiecksymbol bezeichnet. Eine Verteilung der Defekte D2 der zweiten Defektart ist in Figur 2 und den folgenden Figuren mit einem Sternsymbol bezeichnet. Eine Verteilung der Defekte D3 der dritten Defektart ist in Figur 2 und den folgenden Figuren mit einem Diamantsymbol bezeichnet.

In Figur 3 ist ein zweiter Zustand für die erste Verteilung p der Defekte über den Abstand x von der zweiten Elektrode 104 dargestellt. Im Beispiel ist der zweite Zustand ein im Betrieb des Halbleiterbauelements 100 mit der ersten Spannung U1 auf den Anfangszustand folgender Betriebszustand vor einem ersten Durchbruch, in dem sich bereits Defekte D2 der zweiten Defektart am Interface der ersten Elektrode 102 anlagern.

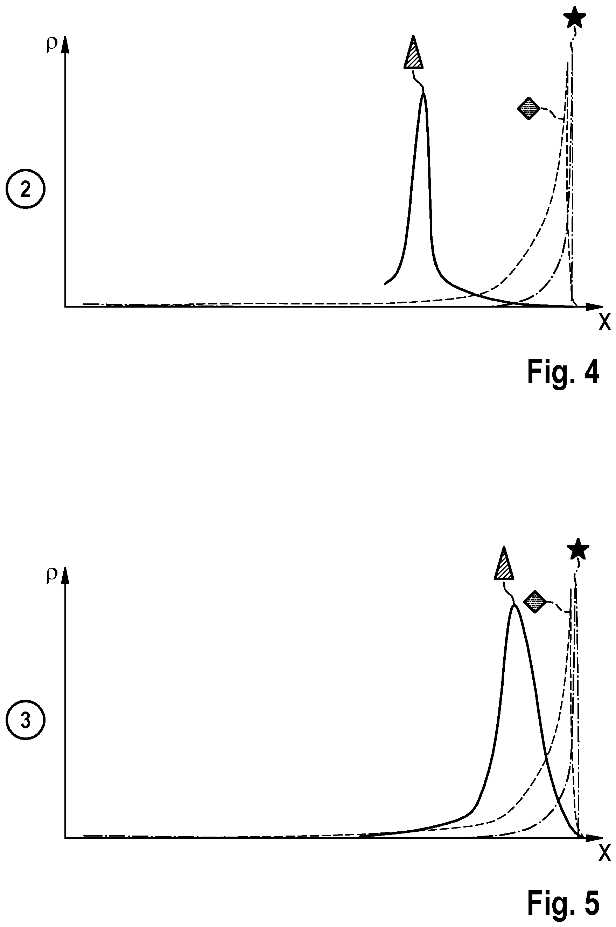

In Figur 4 ist ein dritter Zustand für die erste Verteilung p der Defekte über den Abstand x von der zweiten Elektrode 104 dargestellt. Im Beispiel ist der dritte Zustand ein im Betrieb des Halbleiterbauelements 100 mit der ersten Spannung U1 auf den zweiten Zustand folgender Betriebszustand vor einem ersten Durchbruch, in dem sich bereits Defekte D2 der zweiten Defektart und Defekte D3 der dritten Defektart am Interface der ersten Elektrode 102 anlagern. In dieser Situation ist es im Beispiel noch möglich, eine Lebensdauer des Halbleiterbauelements durch Maßnahmen, die die Defekte vom Interface wegbewegen, zu verlängern.

In Figur 5 ist ein vierter Zustand für die erste Verteilung p der Defekte über den Abstand x von der zweiten Elektrode 104 dargestellt. Im Beispiel ist der vierte Zustand ein im Betrieb des Halbleiterbauelements 100 mit der ersten Spannung U1 auf dritten Zustand folgender Betriebszustand vor einem ersten Durchbruch, in dem sich bereits Defekte D2 der zweiten Defektart und Defekte D3 der dritten Defektart am Interface der ersten Elektrode 102 anlagern und Defekte D1 der ersten Defektart das Interface erreichen. In dieser Situation ist es im Beispiel noch möglich, vor einem Performanceverlust eine Warnung auszugeben.

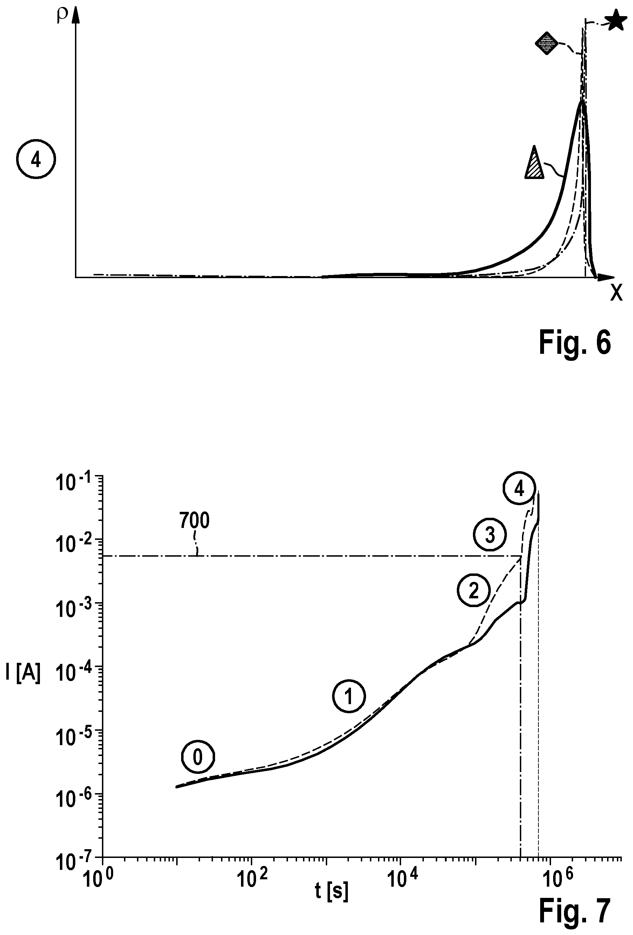

In Figur 6 ist ein fünfter Zustand für die erste Verteilung p der Defekte über den Abstand x von der zweiten Elektrode 104 dargestellt. Im Beispiel ist der fünfte Zustand ein im Betrieb des Halbleiterbauelements 100 mit der ersten Spannung U1 auf den vierten Zustand folgender Betriebszustand in dem sich Defekte D1 der ersten Defektart, Defekte D2 der zweiten Defektart und Defekte D3 der dritten Defektart am Interface der ersten Elektrode 102 anlagern und ein Performanceverlust eintritt.

In Figur 7 ist ein Verlauf eines Leckstromlevel I über der Zeit t zur Früherkennung einer Restlebenszeit dargestellt. In dem in Figur 7 dargestellten Beispiel tritt der Performanceverlust ausgehend vom Anfangszustand nach ca. $10^6$ Sekunden des Betriebs mit der ersten Spannung U1 auf.

In Figur 7 sind beispielhaft die Leckstromlevel I für die in den Figuren 2 bis 6 beschriebenen Zustände gekennzeichnet. Der erste Zustand ist mit 0 gekennzeichnet, der zweite Zustand ist mit 1 gekennzeichnet, der dritte Zustand ist mit 2 gekennzeichnet, der vierte Zustand ist mit 3 gekennzeichnet und der fünfte Zustand ist mit 4 gekennzeichnet.

Für eine Früherkennung der Restlebenszeit ist ein beispielhaftes Leckstromlevel 700 vorgesehen, bei dessen erreichen z.B. eine Warnung ausgegeben wird.

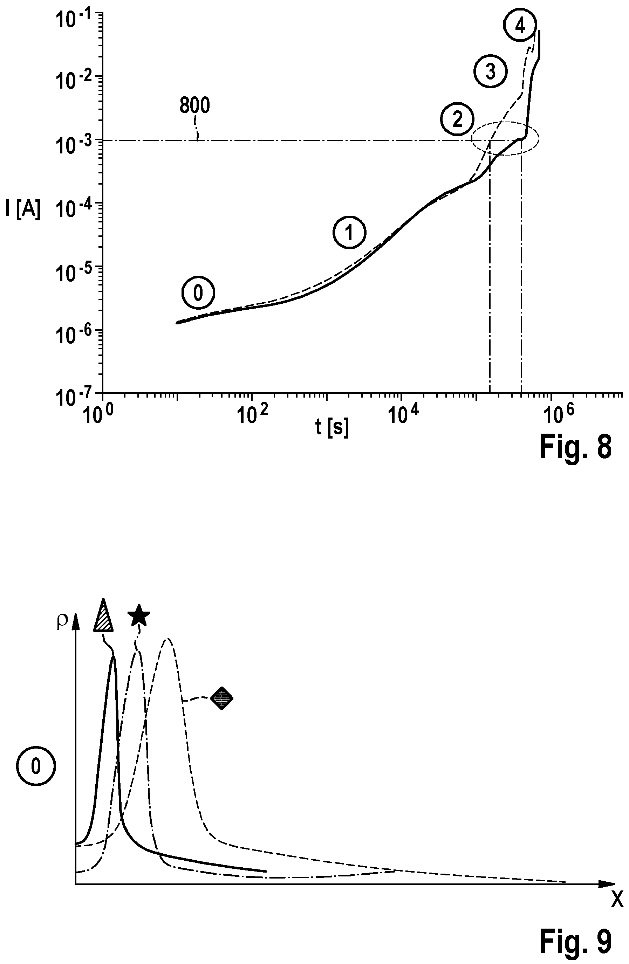

In Figur 8 ist ein Verlauf eines Leckstromlevel I über der Zeit t zur Einleitung einer elektrischen Belastung mit der zweiten Spannung U2 für eine Umkehr der Defektanalagerung dargestellt. In dem in Figur 8 dargestellten Beispiel tritt der Performanceverlust ausgehend vom Anfangszustand nach ca. $10^6$ Sekunden des Betriebs mit der ersten Spannung U1 auf.

In Figur 8 sind beispielhaft die Leckstromlevel I für die in den Figuren 2 bis 6 beschriebenen Zustände gekennzeichnet. Der erste Zustand ist mit 0 gekennzeichnet, der zweite Zustand ist mit 1 gekennzeichnet, der dritte Zustand ist mit 2 gekennzeichnet, der vierte Zustand ist mit 3 gekennzeichnet und der fünfte Zustand ist mit 4 gekennzeichnet.

Für die elektrischen Belastung mit der zweiten Spannung U2 für die Umkehr der Defektanalagerung ist ein beispielhaftes Leckstromlevel 800 vorgesehen, bei dessen erreichen diese gestartet wird.

In Figur 9 ist eine erster Zustand für eine zweite Verteilung p der Defekte über einen Abstand x von der zweiten Elektrode 104 dargestellt. Im Beispiel ist der erste Zustand ein Anfangszustand. Eine Verteilung der Defekte D1 der ersten Defektart ist in Figur 9 und den folgenden Figuren mit einem Dreiecksymbol bezeichnet. Eine Verteilung der Defekte D2 der zweiten Defektart ist in Figur 9 und den folgenden Figuren mit einem Sternsymbol bezeichnet. Eine Verteilung der Defekte D3 der dritten Defektart ist in Figur 9 und den folgenden Figuren mit einem Diamantsymbol bezeichnet.

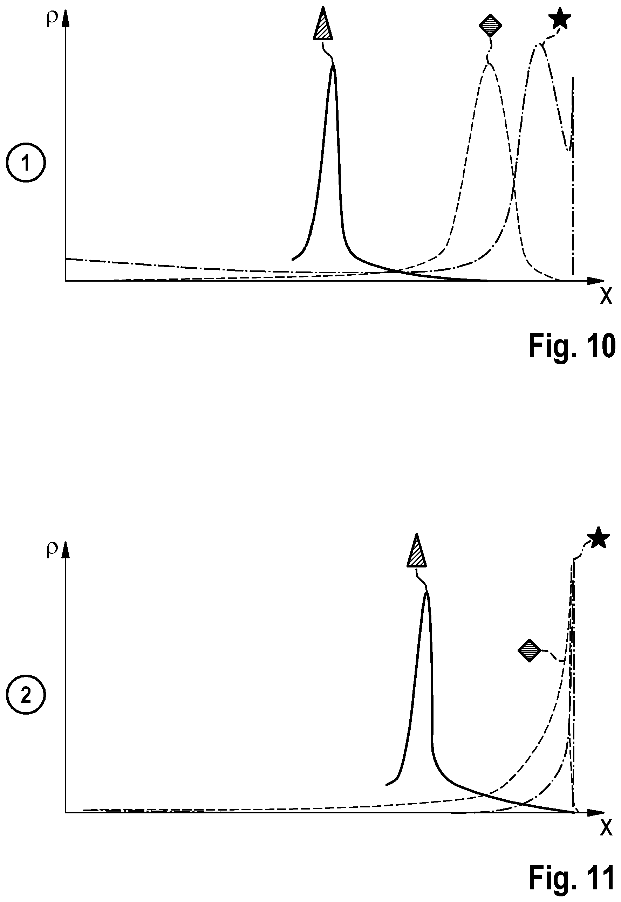

In Figur 10 ist ein zweiter Zustand für die zweite Verteilung p der Defekte über den Abstand x von der zweiten Elektrode 104 dargestellt. Im Beispiel ist der zweite Zustand ein im Betrieb des Halbleiterbauelements 100 mit der ersten Spannung U1 auf den Anfangszustand folgender Betriebszustand vor einem ersten Durchbruch, in dem sich bereits Defekte D2 der zweiten Defektart am Interface der ersten Elektrode 102 anlagern.

In Figur 11 ist eine dritter Zustand für die zweite Verteilung p der Defekte über den Abstand x von der zweiten Elektrode 104 dargestellt. Im Beispiel ist der dritte Zustand ein im Betrieb des Halbleiterbauelements 100 mit der ersten Spannung U1 auf den zweiten Zustand folgender Betriebszustand bei einem frühen Zeitpunkt des Performanceverlusts, in dem sich bereits Defekte D2 der zweiten Defektart und Defekte D3 der dritten Defektart am Interface der ersten Elektrode 102 anlagern. In dieser Situation ist es im Beispiel möglich, eine frühzeitige Warnung auszulösen, aufgrund der eine Wartung des Halbleiterbauelements 100 durchgeführt wird. Der Grenzwert für die frühzeitige Warnung ist beispielweise so gewählt, dass die Warnung ausgelöst wird, wenn ausgehend vom Anfangszustand ca. 10 % der Lebensdauer des Halbleiterbauelements 100 vergangen sind. Der Performance-Verlust tritt im Beispiel zu diesem Zeitpunkt noch nicht merklich ein, da jeder Einzeldurchbruch in der Regel nur eine sehr kleine Fläche zerstört. Dies ist zwar im Strom detektierbar aber bezüglich einer Funktion eines Produkts, z.B. eines Aktorik-Produkts, das das Hableiterbauelement 100 umfasst nicht bemerkbar.

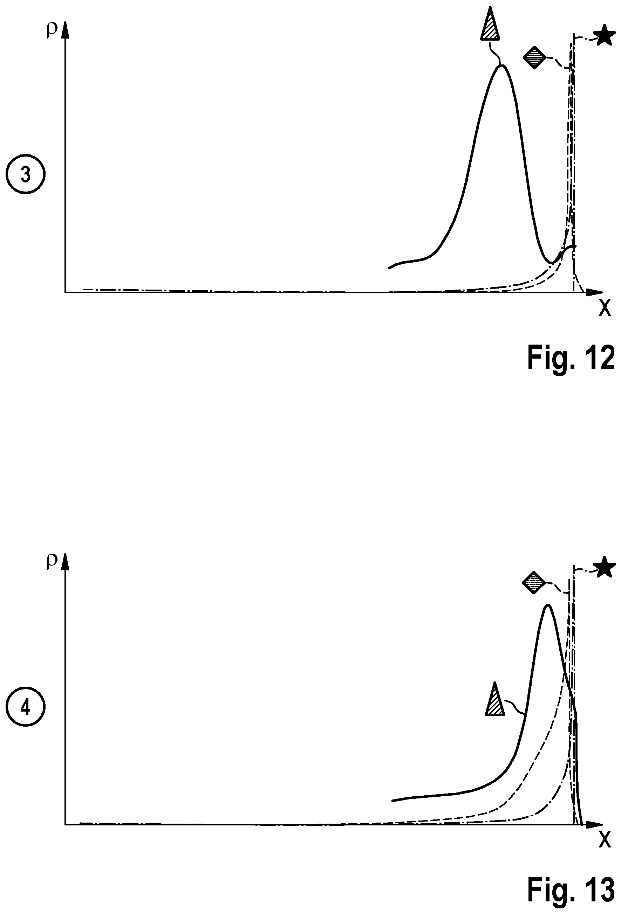

In Figur 12 ist ein vierter Zustand für die zweite Verteilung p der Defekte über den Abstand x von der zweiten Elektrode 104 dargestellt. Im Beispiel ist der vierte Zustand ein im Betrieb des Halbleiterbauelements 100 mit der ersten Spannung U1 auf den dritten Zustand folgender Betriebszustand vor einem ersten Durchbruch, in dem sich bereits Defekte D2 der zweiten Defektart und Defekte D3 der dritten Defektart am Interface der ersten Elektrode 102 anlagern und Defekte D1 der ersten Defektart das Interface erreichen. In dieser Situation ist es im Beispiel möglich, eine kritische Warnung auszulösen, aufgrund der eine Wartung des Halbleiterbauelements 100 durchgeführt wird. Der Grenzwert für die frühzeitige Warnung ist beispielweise so gewählt, dass die Warnung ausgelöst wird, wenn ausgehend vom Anfangszustand ca. 50 % der Lebensdauer des Halbleiterbauelements 100 vergangen sind. Im Beispiel haben in diesem Zustand bereits mehrere lokale Durchbrüche stattgefunden. Das Leckstromlevel ist dann deutlich höher und detektierbar. Die gesamte, durch viele lokale Durchbrüche, zerstörte Fläche ist jetzt im %-Bereich der Funktion des Produkts merkbar. Daher wird beispielsweise die Warnung ausgegeben. Das Halbleiterbauelement 100 oder das Produkt ist in diesem Zustand im Beispiel noch deutlich vor einem Ausfall.

In Figur 13 ist ein fünfter Zustand für die zweite Verteilung p der Defekte über den Abstand x von der zweiten Elektrode 104 dargestellt. Im Beispiel ist der fünfte Zustand ein im Betrieb des Halbleiterbauelements 100 mit der ersten Spannung U1 auf den vierten Zustand folgender Betriebszustand in dem sich Defekte D1 der ersten Defektart, Defekte D2 der zweiten Defektart und Defekte D3 der dritten Defektart am Interface der ersten Elektrode 102 anlagern und ein massiver Performanceverlust eintritt. Dies ist im Beispiel der Zeitpunkt, zu dem die Lebensdauer des Halbleiterbauelements 100 endet.

Das Ende der Lebensdauer bezieht sich dabei auf die Zeit, zu der das Halbleiterbauelement 100 nicht mehr bestimmungsgemäß verwendbar ist. Diese Grenze kann für unterschiedliche Anwendungen verschieden sein.

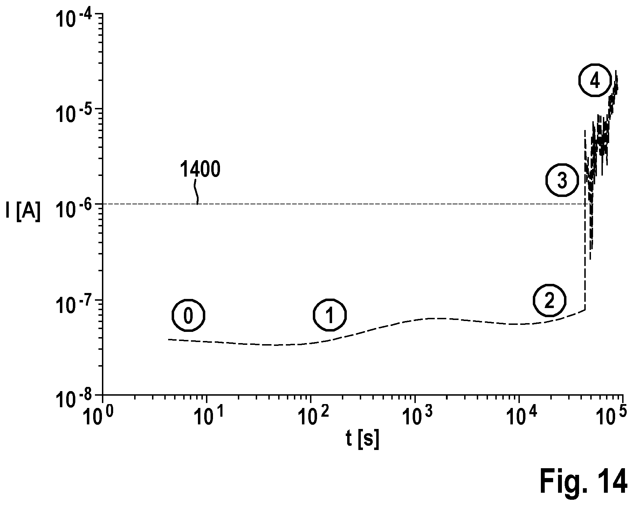

In Figur 14 ist ein Verlauf eines Leckstromlevel I über der Zeit t dargestellt. In dem in Figur 14 dargestellten Beispiel nimmt der Performanceverlust ausgehend vom Anfangszustand zu und erreicht nach ca. $9*10^4$ Sekunden des Betriebs mit der ersten Spannung U1 das Ende der Lebensdauer. Das Ende der Lebensdauer hängt vom Material und den Bedingungen ab. Das Ende der Lebensdauer ist im Beispiel später als der vierte Zustand. ein Performance-Verlust kann jedoch auch nach Erreichen des fünften Zustands noch gering sein.

In Figur 14 sind beispielhaft die Leckstromlevel I für die in den Figuren 9 bis 13 beschriebenen Zustände gekennzeichnet. Der erste Zustand ist mit 0 gekennzeichnet, der zweite Zustand ist mit 1 gekennzeichnet, der dritte Zustand ist mit 2 gekennzeichnet, der vierte Zustand ist mit 3 gekennzeichnet und der fünfte Zustand ist mit 4 gekennzeichnet.

Für eine kritische Warnung ist ein beispielhaftes Leckstromlevel 1400 vorgesehen, bei dessen erreichen z.B. die kritische Warnung ausgegeben wird.

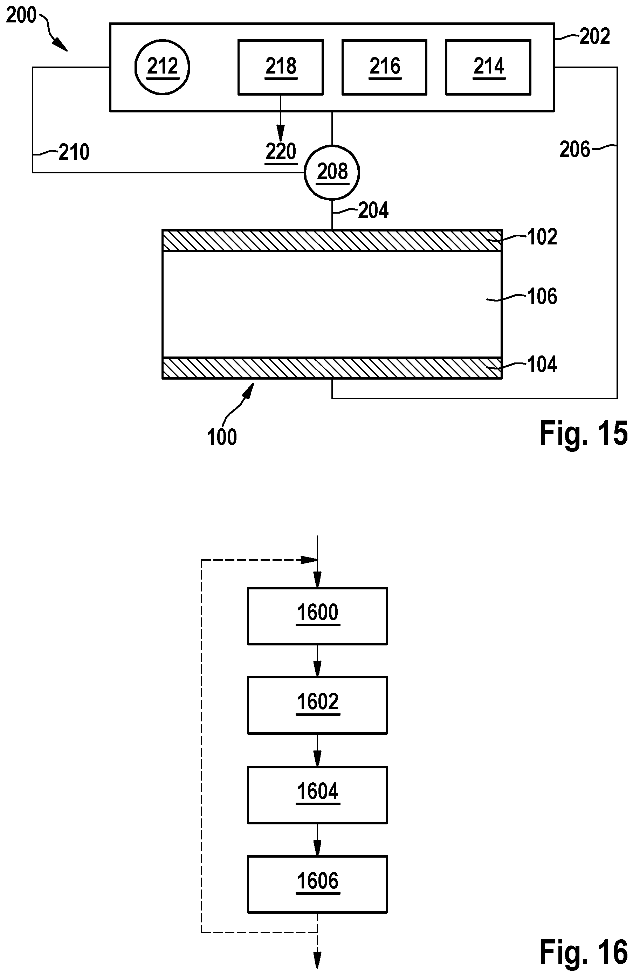

In Figur 15 ist eine Vorrichtung 200 zur Herstellung des Halbleiterbauelements 100 gemäß der ersten Ausführung schematisch dargestellt.

Die Vorrichtung 200 umfasst eine Regel- und/oder Steuereinrichtung 202, die ausgebildet ist, Schritte in einem im Folgenden beschriebenen Verfahren zur Überwachung des Halbleiterbauelements 100 auszuführen. Die Vorrichtung 200 ist über einen ersten Leiter 204 mit der ersten Elektrode 102 des Halbleiterbauelements 100 zumindest zeitweise verbindbar. Die Vorrichtung 200 ist über einen zweiten Leiter 206 mit der zweiten Elektrode 104 des Halbleiterbauelements 100 zumindest zeitweise verbindbar.

Die Regel- und/oder Steuereinrichtung 202 ist im Beispiel ausgebildet, eine erste Spannung U1 mit einer ersten Polarität auszugeben. Die erste Spannung U1 liegt im Beispiel zwischen der ersten Elektrode 102 und der zweiten Elektrode 104 an, wenn diese mit dem jeweiligen Leiter mit der Vorrichtung 200 verbunden sind und die Regel- und/oder Steuereinrichtung 202 die erste Spannung U1 ausgibt.

Die Regel- und/oder Steuereinrichtung 202 ist optional ausgebildet, eine zweite Spannung U2 mit einer der ersten Polarität entgegengesetzter Polarität auszugeben. Die zweite Spannung U2 liegt im Beispiel zwischen der ersten Elektrode 102 und der zweiten Elektrode 104 an, wenn diese mit dem jeweiligen Leiter mit der Vorrichtung 200 verbunden sind und die Regel- und/oder Steuereinrichtung 202 die zweite Spannung U2 ausgibt.

Die Steuereinrichtung kann ausgebildet sein, eine Wechselspannung oder einen im Wesentlichen konstanten Wert für die erste Spannung U1 und/oder die zweite Spannung U2 auszugeben. Dieser Wert liegt beispielsweise in einem Bereich von 1 Volt bis 80 Volt und beträgt vorzugsweise 1 Volt, 2 Volt oder 5 Volt oder 10 Volt oder 20 Volt oder 40 oder 80 Volt.

Bevorzugt ist die dielektrische Schicht 106 als polykristallines oxidisches high-k Dielektrika ausgebildet.

Die dielektrische Schicht 106 ist insbesondere als PZT-Schicht ausgebildet. PZT bezeichnet hierbei $Pb(Zr_xTi_{1-x})O_3$.

Die dielektrische Schicht 106 ist insbesondere als KNN-Schicht ausgebildet. KNN bezeichnet hierbei $(K_x Na_{1-x})$ $NbO_3$.

Die dielektrische Schicht 106 kann insbesondere als $HfO_2$-, $HfZrO_2$-, $ZrO_2$-, $BaTiO_3$-, $SrTiO_3$- oder $(Ba_xSr_{1-x})$ $TiO_3$-Schicht ausgebildet sein.

Bevorzugt ist die dielektrische Schicht 106 dotiert. Beispielsweise ist die dielektrische Schicht 106 eine PZT-Schicht, die mit Nickel-Dotiert ist:

$$Pb(Zr_xTi_{1-x})O_3Ni_y.$$

Sowohl die PZT-Schicht als auch die KNN-Schicht kann andere Dotierungen als Nickel aufweisen, beispielsweise Nb, La, Mn, Mg.

Vorzugsweise ist die dielektrische Schicht als gesputterte PZT-Schicht ausgebildet. Hierbei wird das sogenannte Target-Material in einem Plasma auf einem Substrat abgeschieden. Als Target-Material wird beispielsweise PZT verwendet. Bevorzugt weist die gesputterte PZT-Schicht in diesem Zusammenhang eine Abscheidetemperatur von kleiner als 500°C auf.

Bevorzugt ist die Dicke der dielektrischen Schicht im Bereich 500 nm bis 4 $\mu$m. Das ist ein für Aktorik sinnvolle Bereich. Vorzugsweise ist die Schichtdicke 1 $\mu$m, oder 4 $\mu$m. Größere Schichtdicken sind ebenfalls möglich. Das beschriebene Vorgehen ist für alle Schichtdicken ausführbar.

Geringere Schichtdicken sind ebenfalls möglich. Bevorzugt ist die Dicke der dielektrischen Schicht im Bereich kleiner 500 nm beispielweise für Anwendungen abseits der Aktorik. Ein Beispiel dafür ist eine Anwendung von high-k Dielektrika, z.B. als Speicher. Der Speicher kann ein resistive Random Access Memory, ReRAM, oder ein ferroelectric Random Access Memory, FeRAM, sein. Für diese anderen Anwendungen sind je nach Anwendung Dicken von 15 nm - 200 nm sinnvoll.

Zusätzlich sind sehr dünne high-k Dielektrika mit Schichten z.B. als Gate-Oxide in sehr vielen Anwendungen einsetzbar. Als dielektrische Schicht 106 kann z.B. HfO2 oder SiO2 mit einer Schichtdicke kleiner oder gleich 50nm vorgesehen sein.

Die Regeleinrichtung kann ausgebildet sein, einen Sollwert für die erste Spannung U1 einzuregeln. Dieser Sollwert liegt beispielsweise in einem Bereich von 1 Volt bis 80 Volt und beträgt vorzugsweise 1 Volt, 2 Volt oder 5 Volt oder 10 Volt oder 20 Volt oder 40 oder 80 Volt..

Die Regeleinrichtung kann ausgebildet sein, einen Sollwert für die zweite Spannung U2 einzuregeln. Dieser Sollwert liegt beispielsweise in einem Bereich von 1 Volt bis 80 Volt und beträgt vorzugsweise 1 Volt, 2 Volt oder 5 Volt oder 10 Volt oder 20 Volt oder 40 oder 80 Volt..

In diesem Fall kann eine Spannungsmesseinrichtung vorgesehen sein, die ausgebildet ist, die Spannung zwischen der ersten Elektrode 102 und der zweiten Elektrode 104 zu erfassen. Die Regeleinrichtung ist in diesem Fall ausgebildet, eine Regelabweichung zu reduzieren, die abhängig von einer Differenz dieser erfassten Spannung zum Sollwert bestimmt wird.

Die Vorrichtung 200 umfasst im Beispiel optional eine Messeinrichtung 208. Die Messeinrichtung 208 ist im Beispiel ausgebildet, den Strom der durch die erste Elektrode 102 und die zweite Elektrode 104 fließt zu messen.

Die Messeinrichtung 208 ist im Beispiel im ersten Leiter 204 angeordnet. Eine entsprechende Anordnung an einer anderen Stelle ist ebenfalls möglich.

Die Messeinrichtung 208 ist im Beispiel über eine Signalleitung 210 mit der Regel- und/oder Steuereinrichtung 202 zur Übertragung des gemessenen Strom verbunden.

Der Leckstrom ist stark temperaturabhängig. Es kann vorgesehen sein, dass die Messeinrichtung 208 eine Einrichtung zur Bestimmung einer aktuellen Temperatur T umfasst. Eine Temperaturmessung erfolgt am Halbleiterbauelement 100 oder in dessen direkter Umgebung. Der Grenzwert G bei der Temperatur T wird in diesem Aspekt in Abhängigkeit zu einem Referenzgrenzwert G0 bei einer Referenztemperatur T0 gemäß des folgenden exponentiellen Zusammenhangs bestimmt:

$$G\,(T,T0) \;=\; G0 \;*\; \frac{e^{(-\frac{k}{k_BT})}}{e^{(-\frac{k}{k_BT_0})}}$$

k ist hierbei eine Konstante. Die Konstante beschreibt eine effektive Barrierenhöhe zu diesem Zeitpunkt.

Die Vorrichtung 200 umfasst im Beispiel eine Spannungs- und/oder Stromquelle 212 zur Ausgabe der Spannungen. Die Vorrichtung 200 umfasst im Beispiel eine Recheneinrichtung 214, insbesondere einen Mikroprozessor, die ausgebildet ist die im folgenden beschriebenen Verfahren auszuführen. Die Vorrichtung 200 umfasst im Beispiel einen Speicher 216, der ausgebildet ist, Grenzwerte oder eine Kennlinie aus der Grenzwerte bestimmbar sind, abzuspeichern.

Die Vorrichtung 200 umfasst im Beispiel eine Ausgabeeinrichtung 218, die ausgebildet ist, eine Ausgabe 220 auszugeben.

Ein Speicher, Aktuator, MEMS, Mikrospiegel, Druckkopf oder Lautsprecher kann diese Vorrichtung zum Überwachen des Halbleiterbauelements 100 und das Halbleiterbauelement 100 umfassen. Es kann vorgesehen sein, ein lifetime monitoring für den Speicher, Aktuator, MEMS, Mikrospiegel, Druckkopf oder Lautsprecher durchzuführen, bei dem das Halbleiterbauelement 100 überwacht wird.

Das Verfahren zum Überwachen des Halbleiterbauelements 100 wird im Folgenden anhand der Figur 16 beschrieben.

In einem Schritt 1600 wird das Halbleiterbauelement 100 in einem ersten Betriebsmodus betrieben, in dem die erste Spannung U1 anliegt.

In einem Schritt 1602 wird im Betrieb des Halbleiterbauelements 100 ein Leckstrom I erfasst, der durch die erste Elektrode 102 und die zweite Elektrode 104 des Halbleiterbauelements 100 fliest.

In einem Schritt 1604 wird in einem Aspekt der Leckstrom I in einem Vergleich mit einem ersten Grenzwert, z.B. einem der Leckstromlevel 700, 800, 1400 für den Leckstrom I verglichen. Im Schritt 1604 wird abhängig von einem Ergebnis des Vergleichs die Ausgabe 220 bestimmt. Es kann vorgesehen sein, dass der erste Grenzwert aus einer Vielzahl Grenzwerte bestimmt wird, den der Leckstrom I überschreitet oder unterschreitet.

Es kann vorgesehen sein, eine Spannungs- und/oder Temperaturabhängigkeit des Leckstroms I zu berücksichtigen. Beispielsweise wird der Grenzwert abhängig vom Referenzgrenzwert G0 und der Referenztemperatur T0 insbesondere mit dem oben beschriebenen exponentiellen Zusammenhang bestimmt.

Im Schritt 1604 kann in einem Aspekt ein Zeitpunkt bestimmt werden, zu dem ein Extremalpunkt, insbesondere ein Maximum, des Leckstroms I auftritt. In diesem Aspekt kann die Ausgabe 220 abhängig vom Zeitpunkt bestimmt werden.

Die Ausgabe 220 umfasst einen Zustand des Halbleiterbauelements 100.

Erfindungsgemäß ist vorgesehen, dass abhängig vom Zeitpunkt zu dem der Extremalpunkt, insbesondere das Maximum, des Leckstroms I auftritt, der Restwert der Lebensdauer des Halbleiterbauelements 100 bestimmt wird. In diesem Fall kann die Ausgabe 220 diesen Restwert umfassen.

Beispielsweise wird ein Text bestimmt, der den Zustand des Halbleiterbauelements 100 und eine Angabe über eine noch verbleibende Lebensdauer, z.B. den Restwert, umfasst. Der Restwert ist im Beispiel eine Zeitdauer, für die das Halbleiterbauelement 100 ausgehend von dem Zeitpunkt, zu dem der Leckstrom I erfasst wird, noch mit der ersten Spannung U1 betrieben werden kann, bis der Zeitpunkt eintritt, zu dem die Lebensdauer des Halbleiterbauelements 100 endet. Die Zeitdauer wird beispielsweise ausgehend von dem Zeitpunkt, zu dem der Leckstrom I erfasst wird mit dem zuvor beschriebenen Zusammenhang für die Bewegung von Defekten unter dem Einfluss der ersten Spannung U1 bis zu dem für die jeweilige Anwendung sinnvollen Zeitpunkt für das Ende der Lebensdauer berechnet.

In einem Aspekt wird ein Steuersignal bestimmt, das einen Betriebsmodus für das Halbleiterbauelement 100 vorgibt.

In einem Schritt 1606 wird die Ausgabe 220 ausgegeben.

Beispielsweise wird der Text in einer Nachricht versendet oder an einer Mensch-Maschine-Schnittstelle ausgegeben.

Beispielsweise wird das Steuersignal ausgeben, um das Halbleiterbauelement 100 oder eine Gerät, das das Halbleiterbauelement 100 umfasst, zum Betrieb in dem Betriebsmodus anzusteuern.

Anschließend wird der Schritt 1600 insbesondere mit dem dafür vorgegebenen Betriebsmodus ausgeführt. Es kann vorgesehen sein, das Verfahren aus einem der Gründe zu beenden, die im Folgenden beschrieben werden.

Es kann vorgesehen sein, dass der Leckstrom I in einem Betrieb des Halbleiterbauelements 100 im ersten Betriebsmodus erfasst wird und der Betrieb des Halbleiterbauelements 100 im Schritt 1602 im ersten Betriebsmodus fortgesetzt wird, wenn der Leckstrom I den ersten Grenzwert überschreitet oder wenn der Restwert der Lebensdauer größer als ein erster Schwellwert ist.

Es kann vorgesehen sein, dass in diesem Fall anschließend ein zweiter Grenzwert aus der Vielzahl der Grenzwerte bestimmt wird und der Betrieb des Halbleiterbauelements 100 entweder in einem zweiten Betriebsmodus fortgesetzt oder der Betrieb beendet wird, wenn der Leckstrom I den zweiten Grenzwert überschreitet. Mit zunehmendem Leckstromlevel werden somit verschiedene Maßnahmen ergriffen.

Es kann alternativ dazu vorgesehen sein, dass der Betrieb des Halbleiterbauelements 100 entweder in einem zweiten Betriebsmodus fortgesetzt wird oder beendet wird. Der Betrieb kann im zweiten Betriebsmodus fortgesetzt werden, wenn der Restwert der Lebensdauer kleiner als ein zweiter Schwellwert ist. Der Betrieb kann beendet werden, wenn der Restwert der Lebensdauer größer als der zweite Schwellwert ist. Mit abnehmendem Restwert können verschiedene Maßnahmen ergriffen.

**Patentansprüche**

1. Verfahren zum Überwachen eines Halbleiterbauelements (100), wobei in einem Betrieb des Halbleiterbauelements (100) ein Leckstrom (I) erfasst wird (1602), der durch eine erste Elektrode (102) und eine zweite Elektrode (104) des Halbleiterbauelements (100) fließt,

   wobei ein Zeitpunkt (1604) bestimmt wird, zu dem ein Extremalpunkt, insbesondere ein Maximum, des Leckstroms (I) auftritt und abhängig vom Zeitpunkt eine Ausgabe (220) bestimmt wird, wobei die Ausgabe einen Zustand des Halbleiterbauelements (100) umfasst, und die Ausgabe (220) ausgegeben wird (1606) und wobei optional der Leckstrom (I) in einem Vergleich mit einem ersten Grenzwert (700, 800, 1400) für den Leckstrom (I) verglichen wird und abhängig von einem Ergebnis des Vergleichs eine Ausgabe (220) bestimmt wird (1604),
   **dadurch gekennzeichnet, dass** abhängig vom Zeitpunkt, zu dem der Extremalpunkt, insbesondere das Maximum, des Leckstroms (I) auftritt, ein Restwert einer Lebensdauer des Halbleiterbauelements (100) bestimmt wird (1604), wobei die Ausgabe (220) den Restwert umfasst.

2. Verfahren nach Anspruch 1, **dadurch gekennzeichnet,**
   **dass** der Leckstrom (I) in einem Betrieb des Halbleiterbauelements (100) in einem ersten Betriebsmodus erfasst wird (1602), wobei der Betrieb des Halbleiterbauelements (100) im ersten Betriebsmodus fortgesetzt wird (1602), wenn der Leckstrom (I) den ersten Grenzwert (700, 800) überschreitet oder wenn der Restwert der Lebensdauer größer als ein erster Schwellwert ist.

3. Verfahren nach Anspruch 2, **dadurch gekennzeichnet, dass** ein zweiter Grenzwert (1400) aus der Vielzahl der Grenzwerte bestimmt wird, wobei der Betrieb des Halbleiterbauelements (100) in einem zweiten Betriebsmodus fortgesetzt wird (1602) oder der Betrieb beendet wird, wenn der Leckstrom (I) den zweiten Grenzwert (1400) überschreitet oder dass der Betrieb des Halbleiterbauelements (100) in einem zweiten Betriebsmodus fortgesetzt wird (1602) oder der Betrieb beendet wird, wenn der Restwert der Lebensdauer größer als ein zweiter Schwellwert ist.

4. Verfahren nach einem der vorherigen Ansprüche, **dadurch gekennzeichnet, dass** ein Referenzgrenzwert und eine Referenztemperatur vorgegeben werden, eine aktuelle Temperatur des Halbleiterbauelements (100) oder einer Umgebung des Halbleiterbauelements (100) bestimmt wird, ein Faktor abhängig von der aktuellen Temperatur und der Referenztemperatur bestimmt wird, der Referenzgrenzwert mit dem Faktor skaliert wird und der erste Grenzwert und/oder der zweite Grenzwert abhängig von dem mit dem Faktor skalierten Referenzgrenzwert bestimmt wird.

5. Verfahren nach einem der vorherigen Ansprüche, **dadurch gekennzeichnet, dass** ein Text bestimmt wird, der den Zustand des Halbleiterbauelements (100) und eine Angabe über eine noch verbleibende Lebensdauer umfasst, wobei der Text in einer Nachricht versendet oder an einer Mensch-Maschine-Schnittstelle ausgegeben wird (1606).

6. Verfahren nach einem der vorherigen Ansprüche, **dadurch gekennzeichnet, dass** ein Steuersignal bestimmt wird (1604), das einen Betriebsmodus für das Halbleiterbauelement (100) vorgibt, wobei das Steuersignal ausgeben wird (1606), um das Halbleiterbauelement (100) oder eine Gerät, das das Halbleiterbauelement umfasst, zum Betrieb in dem Betriebsmodus ansteuert.

7. Vorrichtung (200) zum Überwachen eines Halbleiterbauelements (100), wobei die Vorrichtung (200) eine Messeinrichtung (208), eine Recheneinrichtung (214) und eine Ausgabeeinrichtung (218) umfasst, wobei die Messeinrichtung (208) ausgebildet ist, in einem Betrieb des Halbleiterbauelements (100) einen Leckstrom (I) zu erfassen, der durch eine erste Elektrode (102) und eine zweite Elektrode (104) des Halbleiterbauelements (100) fließt, wobei die Recheneinrichtung (214) ausgebildet ist, den Leckstrom (I) in einem Vergleich mit einem ersten Grenzwert (700, 800, 1400) für den Leckstrom (I) zu vergleichen und abhängig von einem Ergebnis des Vergleichs eine Ausgabe (220) zu bestimmen und/oder wobei die Recheneinrichtung (214) ausgebildet ist, einen Zeitpunkt zu bestimmen, zu dem ein Extremalpunkt, insbesondere ein Maximum, des Leckstroms (I) auftritt und abhängig vom Zeitpunkt eine Ausgabe (220) zu bestimmen, wobei die Ausgabe einen Zustand des Halbleiterbauelements (100) umfasst, und wobei die Ausgabeeinrichtung (218) ausgebildet ist, die Ausgabe (220) auszugegeben,
   **dadurch gekennzeichnet, dass** die Recheneinheit dazu ausgebildet ist, abhängig vom Zeitpunkt, zu dem der Extremalpunkt, insbesondere das Maximum, des Leckstroms (I) auftritt, einen Restwert einer Lebensdauer des Halbleiterbauelements (100) zu bestimmen, wobei die Ausgabe (220) den Restwert umfasst.

8. MEMS, Speicher, Aktuator, Mikrospiegel, Druckkopf oder Lautsprecher der die Vorrichtung (200) zum Überwachen

**EP 4 272 007 B1**

eines Halbleiterbauelements (100) nach Anspruch 7 und das Halbleiterbauelement (100) umfasst.

**Claims**

1. Method for monitoring a semiconductor component (100), wherein a leakage current (I), which flows through a first electrode (102) and a second electrode (104) of the semiconductor component (100), is detected (1602) during operation of the semiconductor component (100), wherein a time at which an extreme point, in particular a maximum, of the leakage current (I) occurs is determined (1604) and an output (220) is determined based on the time, wherein the output includes a state of the semiconductor component (100), and the output (220) is output (1606) and wherein optionally the leakage current (I) is compared with a first limit value (700, 800, 1400) for the leakage current (I) in a comparison and an output (220) is determined (1604) based on a result of the comparison,
**characterized in that** a residual value of a lifetime of the semiconductor component (100) is determined (1604) based on the time at which the extreme point, in particular the maximum, of the leakage current (I) occurs, wherein the output (220) includes the residual value.

2. Method according to Claim 1, **characterized in that** the leakage current (I) is detected (1602) during operation of the semiconductor component (100) in a first operating mode, wherein the operation of the semiconductor component (100) is continued (1602) in the first operating mode when the leakage current (I) exceeds the first limit value (700, 800) or when the residual value of the lifetime is greater than a first threshold value.

3. Method according to Claim 2, **characterized in that** a second limit value (1400) is determined from the plurality of limit values, wherein the operation of the semiconductor component (100) is continued (1602) in a second operating mode or the operation is terminated when the leakage current (I) exceeds the second limit value (1400) or **in that** the operation of the semiconductor component (100) is continued (1602) in a second operating mode or the operation is terminated when the residual value of the lifetime is greater than a second threshold value.

4. Method according to one of the preceding claims, **characterized in that** a reference limit value and a reference temperature are specified, a current temperature of the semiconductor component (100) or of surroundings of the semiconductor component (100) is determined, a factor is determined based on the current temperature and the reference temperature, the reference limit value is scaled by the factor and the first limit value and/or the second limit value is determined based on the reference limit value scaled by the factor.

5. Method according to one of the preceding claims, **characterized in that** a text, which includes the state of the semiconductor component (100) and an indication of a still remaining lifetime, is determined, wherein the text is sent in a message or is output to a human-machine interface (1606).

6. Method according to one of the preceding claims, **characterized in that** a control signal, which specifies an operating mode for the semiconductor component (100), is determined (1604), wherein the control signal is output (1606) in order to actuate the semiconductor component (100) or a unit comprising the semiconductor component for operation in the operating mode.

7. Device (200) for monitoring a semiconductor component (100), wherein the device (200) comprises a measurement unit (208), a computation unit (214) and an output unit (218), wherein the measurement unit (208) is designed to detect a leakage current (I), which flows through a first electrode (102) and a second electrode (104) of the semiconductor component (100), during operation of the semiconductor component (100), wherein the computation unit (214) is designed to compare the leakage current (I) with a first limit value (700, 800, 1400) for the leakage current (I) in a comparison and to determine an output (220) based on a result of the comparison and/or wherein the computation unit (214) is designed to determine a time at which an extreme point, in particular a maximum, of the leakage current (I) occurs and to determine an output (220) based on the time, wherein the output includes a state of the semiconductor component (100), and wherein the output unit (218) is designed to output the output (220),
**characterized in that** the computation unit is designed to determine a residual value of a lifetime of the semiconductor component (100) based on the time at which the extreme point, in particular the maximum, of the leakage current (I) occurs, wherein the output (220) includes the residual value.

8. MEMS, memory, actuator, micromirror, printhead or loudspeaker comprising the device (200) for monitoring a semiconductor component (100) according to Claim 7 and the semiconductor component (100).

## EP 4 272 007 B1

**Revendications**

1. Procédé de surveillance d'un composant semi-conducteur (100), dans lequel un courant de fuite (I) qui circule à travers une première électrode (102) et une seconde électrode (104) du composant semi-conducteur (100) est détecté (1602) pendant le fonctionnement du composant semi-conducteur (100), un instant (1604) lors duquel un point extrême, en particulier un maximum, du courant de fuite (I) se produit est déterminé et une sortie (220) est déterminée en fonction dudit instant, la sortie comprenant un état du composant semi-conducteur (100) et la sortie (220) étant émise en sortie (1606), le courant de fuite (I) étant facultativement comparé, lors d'une comparaison, à une première valeur limite (700, 800, 1400) du courant de fuite (I) et une sortie (220) étant déterminée (1604) en fonction d'un résultat de la comparaison,
   **caractérisé en ce qu'**une valeur résiduelle d'une durée de vie du composant semi-conducteur (100) est déterminée (1604) en fonction de l'instant lors duquel le point extrême, en particulier le maximum, du courant de fuite (I) se produit, la sortie (220) comprenant la valeur résiduelle.

2. Procédé selon la revendication 1, **caractérisé en ce que** le courant de fuite (I) est détecté (1602) lors d'un fonctionnement du composant semi-conducteur (100) dans un premier mode de fonctionnement, le fonctionnement du composant semi-conducteur (100) étant poursuivi (1602) dans le premier mode de fonctionnement lorsque le courant de fuite (I) dépasse la première valeur limite (700, 800) ou lorsque la valeur résiduelle de la durée de vie est supérieure à une première valeur de seuil.

3. Procédé selon la revendication 2, **caractérisé en ce qu'**une seconde valeur limite (1400) est déterminée à partir de la pluralité de valeurs limites, le fonctionnement du composant semi-conducteur (100) étant poursuivi (1602) dans un second mode de fonctionnement ou le fonctionnement étant interrompu lorsque le courant de fuite (I) dépasse la seconde valeur limite (1400) ou **en ce que** le fonctionnement du composant semi-conducteur (100) est poursuivi (1602) dans un second mode de fonctionnement ou le fonctionnement est interrompu lorsque la valeur restante de la durée de vie est supérieure à une seconde valeur de seuil.

4. Procédé selon l'une des revendications précédentes, **caractérisé en ce qu'**une valeur limite de référence et une température de référence sont pré-définies, une température actuelle du composant semi-conducteur (100) ou d'un environnement du composant semi-conducteur (100) est déterminée, un facteur est déterminé en fonction de la température actuelle et de la température de référence, la valeur limite de référence est mise à l'échelle conformément audit facteur et la première valeur limite et/ou la seconde valeur limite est déterminée en fonction de la valeur limite de référence mise à l'échelle conformément audit facteur.

5. Procédé selon l'une des revendications précédentes, **caractérisé en ce qu'**un texte qui comprend l'état du composant semi-conducteur (100) et une indication d'une durée de vie restante est déterminé, le texte étant envoyé dans un message ou délivré à une interface homme-machine (1606).

6. Procédé selon l'une des revendications précédentes, **caractérisé en ce qu'**un signal de commande (1604) qui spécifie un mode de fonctionnement du composant semi-conducteur (100) est déterminé, le signal de commande étant émis en sortie (1606) pour commander le composant semi-conducteur (100) ou un appareil qui comprend le composant semi-conducteur afin de le faire fonctionner dans ledit mode de fonctionnement.

7. Dispositif (200) destiné à surveiller un composant semi-conducteur (100), le dispositif (200) comprenant un dispositif de mesure (208), un dispositif de calcul (214) et un dispositif de sortie (218), le dispositif de mesure (208) étant conçu pour détecter un courant de fuite (I) qui circule à travers une première électrode (102) et une seconde électrode (104) du composant semi-conducteur (100) pendant le fonctionnement du composant semi-conducteur (100), le dispositif de calcul (214) étant conçu pour comparer, lors d'une comparaison, le courant de fuite (I) à une première valeur limite (700, 800, 1400) du courant de fuite (I) et pour déterminer une sortie (220) en fonction d'un résultat de la comparaison et/ou le dispositif de calcul (214) étant conçu pour déterminer un instant lors duquel un point extrême, en particulier un maximum, du courant de fuite (I) se produit et pour déterminer une sortie (220) en fonction dudit instant, la sortie comprenant un état du composant semi-conducteur (100), et le dispositif de sortie (218) étant conçu pour émettre en sortie ladite sortie (220),
   **caractérisé en ce que** l'unité de calcul est conçue pour déterminer une valeur résiduelle d'une durée de vie du composant semi-conducteur (100) en fonction de l'instant lors duquel le point extrême, en particulier le maximum, du courant de fuite (I) se produit, la sortie (220) comprenant la valeur résiduelle.

8. MEMS, mémoire, actionneur, micro-miroir, tête d'impression ou haut-parleur comprenant le dispositif (200) destiné à surveiller un composant semi-conducteur (100) selon la revendication 7 et le composant semi-conducteur (100).

Fig. 1

Fig. 2

Fig. 3

Fig. 4

Fig. 5

Fig. 6

Fig. 7

**Fig. 8**

**Fig. 9**

Fig. 10

Fig. 11

Fig. 12

Fig. 13

Fig. 14

200

202

( 212 )    218    216    214

210

220

( 208 )

204

102

106

104

100

**Fig. 15**

1600

1602

1604

1606

**Fig. 16**

**IN DER BESCHREIBUNG AUFGEFÜHRTE DOKUMENTE**

**In der Beschreibung aufgeführte Patentdokumente**

- DE 102016109137 B3
- US 2019369157 A1
- US 6348806 B1

**In der Beschreibung aufgeführte Nicht-Patentliteratur**

- **VON REIS DANIEL MONTEIRO DINIZ**. *Leakage Current in Low-Temperature PVD PZT Films*